# FASCICULE DE BREVET EUROPEEN

(11) **EP 1 219 968 B1**
(45) Date de publication et mention de la délivrance du brevet: **14.11.2007**
(21) Numéro de dépôt: 01403305.4
(22) Date de dépôt: 20.12.2001
(51) Int. Cl.: G01R 31/00

(54) **Démarreur de véhicule automobile et procédé de contrôle du fonctionnement d'un tel démarreur**
Anlasser für ein automobiles Fahrzeug und Steuerungsverfahren für den Betrieb eines solchen Anlassers
Automobile vehicle starter and controlling method for the running of such a starter

(30) Priorité: 28.12.2000 FR 0017211
(43) Date de publication de la demande: 03.07.2002
(73) Titulaire: VALEO EQUIPEMENTS ELECTRIQUES MOTEUR, 94017 Créteil Cedex (FR)
(72) Inventeur: Maillet, Régis, 38680 St. Alban de Roche (FR)
(74) Mandataire: Gamonal, Didier

(56) Documents cités:
- DE-A- 19 811 176
- JP-A- 60 113 042
- US-A- 5 257 190
- US-A- 5 281 919

## Description

La présente invention concerne un démarreur de véhicule automobile. Elle concerne également un procédé de contrôle du fonctionnement d'un tel démarreur.

Un démarreur de véhicule automobile comporte classiquement un moteur électrique adapté à entraîner en rotation un lanceur doté d'un pignon destiné à coopérer avec l'engrenage de la couronne de démarrage du moteur thermique du véhicule. Le moteur électrique est raccordé, d'une part, à la masse, et d'autre part, à la borne positive de la batterie d'alimentation du véhicule par l'intermédiaire d'un contacteur électromagnétique.

Le contacteur est piloté à la fermeture par un microcontrôleur lorsqu'un interrupteur à commande par clé de contact est actionné par un utilisateur pour provoquer l'alimentation du moteur en énergie électrique.

Un tel démarreur est par exemple connu du document FR 00 082 093 publié sous le numéro FR-A-2 795 884.

Certains types de démarreurs sont pourvus de moyens de protection, notamment contre des surchauffes et des surcharges. Tel est par exemple le cas du démarreur décrit dans le document FR 97 13 351 publié sous le numéro FR-A-2 770 349, dans lequel le circuit de commande de l'alimentation du moteur électrique du démarreur comporte un circuit RC qui se charge et se décharge selon que l'interrupteur à commande par clé de contact est ouvert ou fermé, et qui présente une constante de temps de charge plus petite que sa constante de temps de décharge de manière à empêcher l'alimentation du moteur lorsque la valeur de la tension aux bornes des moyens capacitifs du circuit RC est supérieure à un seuil donné.

On évite ainsi, notamment, toute surchauffe du démarreur susceptible d'engendrer sa destruction, en particulier dans le cas où, en cas de difficulté de démarrage du moteur thermique du véhicule, l'utilisateur sollicite à plusieurs reprise le démarreur dans l'espoir de faire démarrer le moteur.

Le document JP-A-60 113042 divulgue un système de contrôle d'un démarreur électrique où les données stockées sont affichées selon différentes périodes. Le document US-A-5 257190 divulgue un système de management en temps réel d'un véhicule utilisant un microprocesseur. Le document DE-A-198 11 176 divulgue un dispositif et procédé de commande d'un démarreur électrique pour lancer un moteur à combustion interne.

Cependant, les démarreurs de véhicule actuels sont dépourvus de moyens permettant de disposer d'un historique concernant son fonctionnement afin, notamment, de prévenir tout risque de dysfonctionnement et, le cas échéant, de fournir une indication quant à la nécessité de procéder à une maintenance préventive.

Le but de l'invention est de pallier cet inconvénient.

Elle a donc pour objet un démarreur de véhicule automobile, comprenant un microcontrôleur et un moteur électrique raccordé à la batterie du véhicule par l'intermédiaire d'un contacteur commandé par le microcontrôleur pour l'alimentation du moteur en énergie électrique, caractérisé en ce qu'il comporte en outre des moyens de mémorisation de données dans lesquels sont stockées des informations relatives au fonctionnement du démarreur, et en ce que le microcontrôleur comporte, stockés en mémoire, des moyens logiciels aptes à provoquer l'émission des données stockées sur un câble d'interrogation, en réponse à la réception d'un signal d'interrogation.

Ce démarreur peut avantageusement être complété par une ou plusieurs des caractéristiques suivantes, prises isolément ou selon toutes les combinaisons techniquement possibles :
- le câble d'interrogation est constitué par un câble de commande de l'activation du démarreur, qui est raccordé à la batterie du véhicule par l'intermédiaire d'un interrupteur à commande par clé de contact, et qui est pourvu d'une borne de raccordement d'un système de diagnostic.
- le câble d'interrogation est constitué par un bus d'interrogation spécifique en communication avec le microcontrôleur et sur lequel vient se brancher un système de diagnostic.
- le système de diagnostic est intégré à un calculateur embarqué à bord du véhicule automobile.
- les moyens logiciels aptes à provoquer l'émission des données comportent des moyens de décodage du signal d'interrogation et des moyens d'élaboration d'un mot binaire véhiculant des informations extraites des moyens de mémorisation.
- les moyens de mémorisation sont constitués par la mémoire morte du microcontrôleur.
- les moyens de mémorisation sont constitués par une mémoire morte raccordée au microcontrôleur.

L'invention a également pour objet un procédé de contrôle du fonctionnement d'un démarreur de véhicule automobile tel que défini ci-dessus, essentiellement caractérisé en ce qu'il comporte les étapes consistant à mémoriser des informations relatives au fonctionnement du démarreur dans une mémoire de stockage de données et à transférer ces informations sur un câble d'interrogation en réponse à la réception, par le microcontrôleur du démarreur, d'un signal d'interrogation.

Avantageusement, l'étape de mémorisation des données consiste à mémoriser temporairement les informations dans une mémoire vive et à transférer ces informations vers une mémoire morte après démarrage du moteur du véhicule et avant mise en veille du démarreur.

D'autres buts, caractéristiques et avantages de l'invention ressortiront de la description suivante, donnée uniquement à titre d'exemple, et faite en référence aux dessins annexés, sur lesquels :
- la figure 1 est un schéma synoptique d'un démarreur conforme à l'invention ;
- la figure 2 est un schéma synoptique d'un autre mode de réalisation d'un démarreur conforme à l'invention ; et
- la figure 3 est un organigramme illustrant les principales phases du procédé de contrôle du fonctionnement d'un démarreur selon l'invention.

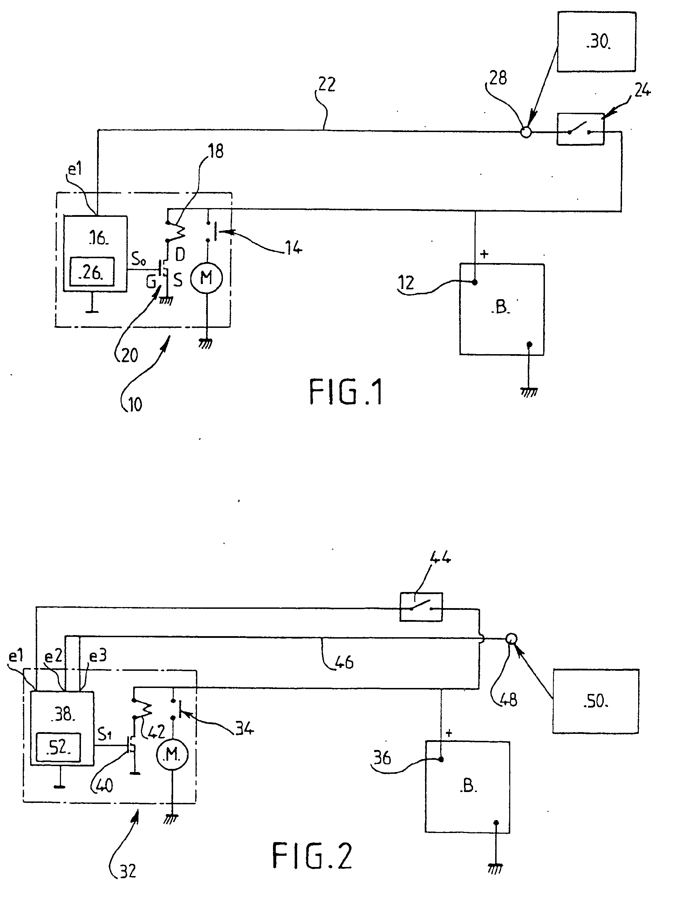

Sur la figure 1, on a représenté un premier exemple de réalisation d'un démarreur conforme à l'invention, désigné par la référence numérique générale 10.

Le démarreur 10 comporte essentiellement, comme visible par exemple à la figure 1 du document FR-A-2 795 884, un moteur électrique M dont l'arbre de sortie est relié, directement ou indirectement par exemple par l'intermédiaire d'un réducteur attelé à un arbre secondaire, à un entraîneur d'un lanceur pourvu d'un pignon destiné à coopérer avec l'engrenage de la couronne de démarrage du moteur thermique du véhicule et qui est raccordé, d'une part, à la masse, et d'autre part, à la borne positive 12 de la batterie B d'alimentation du véhicule automobile, par l'intermédiaire d'un contacteur électromagnétique 14, et un microcontrôleur 16, de type classique, pilotant le contacteur électromagnétique 14 à la fermeture pour provoquer l'alimentation du moteur M.

Le démarreur 10 est en outre pourvu d'une bobine d'excitation 18 appartenant à un contacteur visible à la figure 1 du document FR-A-2 795 884. Cette bobine 18 est d'une part raccordée à la borne positive 12 de la batterie B et, d'autre part, connectée en série sur un transistor 20 fonctionnant en interrupteur, dont la source S est raccordée à la masse, et dont la grille G est raccordée à une sortie si du microcontrôleur 16.

On voit par ailleurs sur la figure 1 que le microcontrôleur 16 et pourvu d'une entrée e1 raccordée à la borne positive 12 de la batterie B par l'intermédiaire d'un interrupteur 24 à commande par clé de contact, de manière connue en soi. En variante l'interrupteur est commandé par un relais à commande par carte électronique.

Conformément à l'invention, le démarreur 10 est pourvu de moyens permettant de surveiller son fonctionnement. Plus précisément les paramètres de fonctionnement du démarreur sont stockés et utilisés qu'en réponse à la réception d'un signal d'interrogation, c'est à dire que ces paramètres ne sont pas immédiatement à leur réception comparés à une valeur de paramètre de consigne pour détecter à tout moment un défaut de fonctionnement.

Ici, le microcontrôleur 16 est pourvu d'une mémoire 26 dans laquelle sont stockées des informations relatives à son fonctionnement, lorsque le démarreur 10 est activé.

Les informations stockées dans la mémoire 26 peuvent être constituées par tout type de données nécessaires au contrôle du bon fonctionnement du démarreur 10, comme par exemple, la durée de chaque activation, la durée de fonctionnement du démarreur, le nombre de cycles de démarrage, le niveau de la batterie B, la température, ...

Ces données peuvent éventuellement être mémorisées pour un nombre prédéterminé de cycles de démarrage ainsi que, de préférence, un nombre prédéterminé de cycles de démarrage en condition extrême, comme par exemple des démarrages à très faible ou à très forte tension, des démarrages à très basse ou à très haute température, des démarrages de très longue durée, ...

Ces informations sont, le cas échéant, délivrées au microcontrôleur par des capteurs appropriés et de type classique associés au démarreur 10.

Par ailleurs, le microcontrôleur 16 comporte, stockés en mémoire, des moyens logiciels adaptés pour provoquer l'émission des données stockées dans la mémoire 26 sur le câble de commande 22 raccordant l'interrupteur 24 au microcontrôleur 16.

En effet, celui-ci est pourvu d'une borne 28 permettant le raccordement d'un système de diagnostic 30.

Ces moyens logiciels comportent, par exemple, des moyens de décodage capables de procéder au décodage d'un signal d'interrogation émis par le système de diagnostic 30 et des moyens logiciels servant à élaborer, en réponse, un mot binaire contenant les informations extraites de la mémoire 26 et ce, en fonction du contenu du signal d'interrogation fourni par le système de diagnostic 30.

On va maintenant décrire, en référence à la figure 2, un autre mode de réalisation d'un démarreur 32 de véhicule automobile conforme à l'invention.

Comme dans l'exemple de réalisation décrit précédemment, le démarreur 32 comporte essentiellement un moteur électrique M raccordé par l'intermédiaire d'un contacteur 34 à la borne positive 36 de la batterie B du véhicule et un microcontrôleur 38 pilotant le contacteur, par l'intermédiaire d'un transistor 40 fonctionnant en interrupteur et d'une bobine d'activation 42, pour provoquer l'alimentation du moteur M en énergie électrique.

Comme dans l'exemple de réalisation décrit précédemment, une entrée e1 du microcontrôleur 38 est raccordée à un câble de commande pourvu d'interrupteur 44 à commande par clé de contact pour provoquer l'activation du démarreur 32.

Le microcontrôleur 38 est pourvu de deux entrées additionnelles e2, e3 assurant son raccordement à un bus d'interrogation spécifique 46 qui est pourvu d'une borne 48 pour le raccordement d'un système 50 de diagnostic.

Comme dans le démarreur décrit en référence à la figure 1, le microcontrôleur 38 est pourvu d'une mémoire 52 servant au stockage d'informations caractéristiques du fonctionnement du démarreur 32 et dans laquelle sont chargés des moyens logiciels de décodage d'un signal d'interrogation émis par le système de diagnostic 50 et des moyens logiciels pour l'élaboration d'un mot binaire destiné à véhiculer les informations extraites du microcontrôleur 38 en fonction du contenu du signal d'interrogation émis par le système de diagnostic 50, et à les transmettre sur le bus d'interrogation 46.

Selon cet exemple de réalisation, de préférence, le bus d'interrogation 46 est constitué par un bus de type K, L, c'est-à-dire un bus correspondant au protocole défini dans la norme ISO 9141 qui concerne généralement pour les équipements automobiles, une interface de liaison appropriée étant, dans ce cas, utilisée pour le raccordement du bus 46 au démarreur 32.

Dans les différents modes de réalisation qui viennent d'être décrits, la mémoire servant au stockage des informations portant sur le fonctionnement du démarreur est intégrée au microcontrôleur. Bien entendu, en variante, elle peut être disposée dans un boîtier distinct, raccordée au microcontrôleur par l'intermédiaire d'un bus de transmission de données approprié.

Cette mémoire peut être constituée par tout type de mémoire appropriée pour l'utilisation envisagée, par exemple une mémoire de type EEPROM ou de type flash.

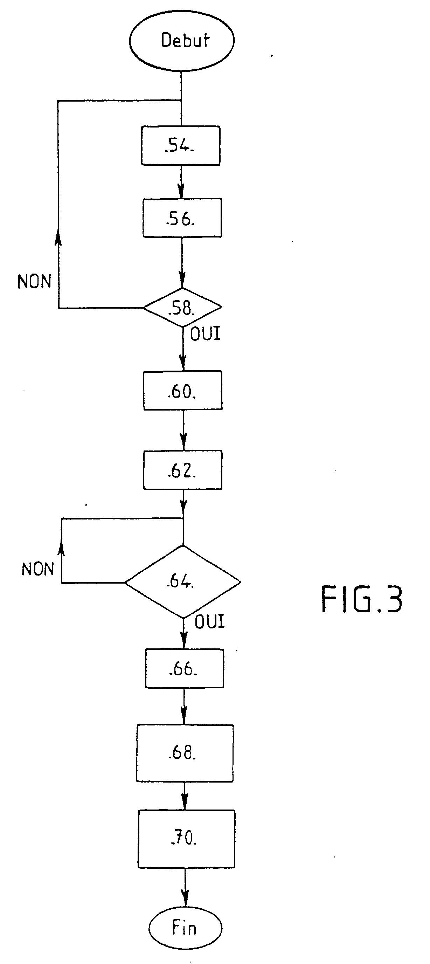

On décrira ci-après, en référence à la figure 3, les principales phases du procédé de contrôle du fonctionnement du démarreur qui vient d'être décrit.

Lorsque le microcontrôleur du démarreur détecte une élévation de tension sur son entrée e1, résultant de la fermeture de l'interrupteur à commande par clé de contact ou autre, au cours d'une première étape 54, il commande l'exécution d'une procédure de démarrage au cours de laquelle il provoque la fermeture du contacteur de manière à provoquer la mise en action du moteur M.

Ce faisant, il récupère les informations correspondant à ses caractéristiques de fonctionnement et les transfère dans sa mémoire vive RAM (étape 56).

Ces étapes 54 et 56 sont effectuées tant que le microcontrôleur détecte une tension haute sur son entrée e1 (étape 58).

Lors de l'étape 60 suivante, dès que le microcontrôleur détecte une chute de tension sur son entrée e1 résultant d'une ouverture de l'interrupteur de clé de contact, il provoque l'ouverture du contacteur électromagnétique de manière à stopper le moteur M et transfère les informations stockées en mémoire vive vers sa mémoire morte puis provoque la mise en veille du démarreur (étape 62).

Lorsque le microcontrôleur se situe en veille, il procède à une phase 64 de surveillance de la réception d'un signal d'interrogation.

Dès que le signal d'interrogation est détecté, il procède à un décodage de ce dernier (étape 66) de manière à récupérer l'indication des informations à émettre vers le système de diagnostic.

Il procède, lors de l'étape 68 suivante, à l'élaboration d'un mot binaire constitué par exemple par une série d'octets, selon code prédéterminé susceptible d'être décodé par le système de diagnostic, de sorte que des séquences d'octets spécifiques correspondent à une information prédéterminée.

Bien entendu, dans le mode de réalisation décrit précédemment en référence à la figure 2, le mot binaire est élaboré selon un code compatible avec la norme K, L.

A l'issu de cette étape, le microcontrôleur procède à la transmission de ces informations sur le câble d'interrogation auquel est raccordé le système de diagnostic (étape 70).

On notera que l'invention qui vient d'être décrite n'est pas limitée au mode de réalisation décrit.

En effet, dans les modes de réalisation envisagés, le système de diagnostic utilisé pour la récupération des informations stockées dans le microcontrôleur du démarreur est constitué par un système spécifique non embarqué.

Bien entendu, il est possible d'intégrer ce système de diagnostic à un calculateur embarqué à bord du véhicule automobile, tel que le calculateur de contrôle du moteur ou le calculateur dont est doté l'habitacle du véhicule.

Dans ce cas, ce calculateur peut être pourvu d'un algorithme spécifique apte à contrôler périodiquement le fonctionnement du démarreur et à élaborer un message d'alerte, par exemple sous la forme d'un signal sonore ou visuel, en cas de détection d'anomalies, notamment en cas de dépassement d'un nombre d'heures de fonctionnement prédéterminé nécessitant le déclenchement d'une opération de maintenance.

Avantageusement le microcontrôleur avec ses moyens logiciels selon l'invention est intégré dans le démarreur en étant monté par exemple sur une carte montée dans le contacteur entre le fond du capot et le noyau fixe de celui-ci.

## Revendications

1. Démarreur de véhicule automobile, comprenant un microcontrôleur (16 ; 38) et un moteur électrique (M) raccordé à la batterie (B) du véhicule par l'intermédiaire d'un contacteur (14 ; 34) commandé par le microcontrôleur (16 ; 38) pour l'alimentation du moteur en énergie électrique, **caractérisé en ce qu'**il comporte en outre des moyens de mémorisation de données (26 ; 52) dans lesquels sont stockées des informations relatives au fonctionnement du démarreur, et **en ce que** le microcontrôleur (16 ; 38) comporte, stockés en mémoire, des moyens logiciels aptes à provoquer l'émission des données stockées sur un câble d'interrogation (22 ; 46) en réponse à la réception d'un signal d'interrogation.

2. Démarreur selon la revendication 1, **caractérisé en ce que** le câble d'interrogation est constitué par un câble (22) de commande de l'activation du démarreur, qui est raccordé à la batterie (B) du véhicule par l'intermédiaire d'un interrupteur (24) à commande par clé de contact, et qui est pourvu d'une borne (28)de raccordement d'un système de diagnostic.

3. Démarreur selon la revendication 1, **caractérisé en ce que** le câble d'interrogation est constitué par un bus d'interrogation (46) spécifique en communication avec le microcontrôleur (38) et sur lequel vient se brancher un système de diagnostic (50).

4. Démarreur selon la revendication 3, **caractérisé en ce que** le système de diagnostic (50) est intégré à un calculateur embarqué à bord du véhicule automobile.

5. Démarreur selon l'une quelconque des revendications 1 à 4, **caractérisé en ce que** les moyens logiciels aptes à provoquer l'émission des données comportent des moyens de décodage du signal d'interrogation et des moyens d'élaboration d'un mot binaire véhiculant des informations extraites des moyens de mémorisation (26 ; 52).

6. Démarreur selon l'une quelconque des revendications 1 à 5, **caractérisé en ce que** les moyens de mémorisation (26 ; 52) sont constitués par la mémoire morte du microcontrôleur.

7. Démarreur selon l'une quelconque des revendications 1 à 5, **caractérisé en ce que** les moyens de mémorisation (26 ; 52) sont constitués par une mémoire morte raccordée au microcontrôleur.

8. Procédé de contrôle du fonctionnement d'un démarreur de véhicule automobile selon l'une quelconque des revendications 1 à 7, **caractérisé en ce qu'**il comporte les étapes consistant mémoriser des informations relatives au fonctionnement du démarreur dans une mémoire (26 ; 52) de stockage de données et à transférer ces informations sur un câble d'interrogation (22 ; 46) en réponse à la réception, par le microcontrôleur (16 ; 38) du démarreur, d'un signal d'interrogation.

9. Procédé de contrôle selon la revendication 8, **caractérisé en ce que** l'étape de mémorisation des données consiste à mémoriser temporairement les informations dans une mémoire vive et à transférer ces informations vers une mémoire morte après démarrage du moteur du véhicule et avant mise en veille du démarreur.

## Claims

1. Motor vehicle starter, comprising a microcontroller (16; 38) and an electric motor (M) which is connected to the battery (B) of the vehicle by means of a contactor (14; 34) which is controlled by the microcontroller (16; 38) for supply of electric energy to the motor, **characterised in that** it additionally comprises means (26; 52) for storage of data in which information relating to the functioning of the starter is stored, and **in that** the microcontroller (16; 38) comprises, stored in its memory, software means which can give rise to the emission of the data stored in an interrogation cable (22; 46) in response to the receipt of an interrogation signal.

2. Starter according to claim 1, **characterised in that** the interrogation cable consists of a cable (22) to control the activation of the starter, which is connected to the battery (B) of the vehicle by means of a switch for control by means of a contact key (24), and which is provided with a terminal (28) for connection to a diagnostic system.

3. Starter according to claim 1, **characterised in that** the interrogation cable consists of an interrogation bus (46) which is specifically for communication with the microcontroller (38), and to which a diagnostic system (50) is connected.

4. Starter according to claim 3, **characterised in that** the diagnostic system (50) is integrated with a computer located on board the motor vehicle.

5. Starter according to any one of claims 1 to 4, **characterised in that** the software means which can give rise to emission of the data comprise means for decoding the interrogation signal and means for processing a binary word which conveys information extracted from the storage means (26; 52).

6. Starter according to any one of claims 1 to 5, **characterised in that** the storage means (26; 52) consist of the read-only memory of the microcontroller.

7. Starter according to any one of claims 1 to 5, **characterised in that** the storage means (26; 52) consist of a read-only memory which is connected to the microcontroller.

8. Method for controlling the functioning of a motor vehicle starter according to any one of claims 1 to 7, **characterised in that** it comprises steps consisting of storing information relating to the functioning of the starter in a data storage memory (26; 52) and of transferring this information in an interrogation cable (22; 46) in response to receipt of an interrogation signal by the microcontroller (16; 38) of the starter.

9. Control method according to claim 8, **characterised in that** the step of storage of the data consists of storing the information temporarily in a read-write memory and of transferring this information to a read-only memory after the motor vehicle has been started, and before the starter powers down.

## Patentansprüche

1. Kraftfahrzeuganlasser, der einen Mikrocontroller (16; 38) und einen Elektromotor (M) umfasst, der an die Batterie (B) des Fahrzeugs über ein Einrückrelais (14; 34) angeschlossen ist, das durch den Mikrocontroller (16; 38) für die Versorgung des Motors mit elektrischer Energie gesteuert wird, **dadurch gekennzeichnet, dass** er außerdem Mittel zur Speicherung von Daten (26; 52) umfasst, in denen Informationen zum Betrieb des Anlassers abgespeichert werden, und dass der Mikrocontroller (16; 38) im Speicher abgespeicherte Software-Mittel umfasst, die in der Lage sind, die Ausgabe der abgespeicherten Daten über ein Abfragekabel (22; 46) als Reaktion auf den Empfang eines Abfragesignals zu bewirken.

2. Anlasser nach Anspruch 1, **dadurch gekennzeichnet, dass** das Abfragekabel aus einem Steuerkabel (22) für die Aktivierung des Anlassers besteht, das an die Fahrzeugbatterie (B) über einen durch den Zündschlüssel betätigten Schalter (24) angeschlossen und mit einer Anschlussklemme (28) zum Anschluss an ein Diagnosesystem versehen ist.

3. Anlasser nach Anspruch 1, **dadurch gekennzeichnet, dass** das Abfragekabel aus einem spezifischen Abfragebus (46) besteht, der mit dem Mikrocontroller (38) kommuniziert und an den ein Diagnosesystem (50) angeschlossen wird.

4. Anlasser nach Anspruch 3, **dadurch gekennzeichnet, dass** das Diagnosesystem (50) in einen Bordrechner des Kraftfahrzeugs integriert ist.

5. Anlasser nach einem der Ansprüche 1 bis 4, **dadurch gekennzeichnet, dass** die Software-Mittel, die in der Lage sind, die Ausgabe der Daten zu bewirken, Mittel zur Decodierung des Abfragesignals und Mittel zur Verarbeitung eines Binärworts umfassen, das die aus den Speichermitteln (26; 52) ausgelesenen Informationen beinhaltet.

6. Anlasser nach einem der Ansprüche 1 bis 5, **dadurch gekennzeichnet, dass** die Speichermittel (26; 52) aus dem Festwertspeicher des Mikrocontrollers bestehen.

7. Anlasser nach einem der Ansprüche 1 bis 5, **dadurch gekennzeichnet, dass** die Speichermittel (26; 52) aus einem an den Mikrocontroller angeschlossenen Festwertspeicher bestehen.

8. Verfahren zur Kontrolle des Betriebs eines Kraftfahrzeuganlassers nach einem der Ansprüche 1 bis 7, **dadurch gekennzeichnet, dass** es Ablaufschritte umfasst, die darin bestehen, Informationen zum Betrieb des Anlassers in einem Speicher (26; 52) zur Abspeicherung von Daten zu speichern und diese Informationen auf einem Abfragekabel (22; 46) als Reaktion auf den Empfang eines Abfragesignals durch den Mikrocontroller (16; 38) des Anlassers zu übertragen.

9. Verfahren nach Anspruch 8, **dadurch gekennzeichnet, dass** der Ablaufschritt zum Speichern der Daten darin besteht, die Informationen vorübergehend in einem Schreib-/Lese-Speicher zu speichern und diese Informationen nach dem Anlassen des Fahrzeugmotors und vor dem Bereitschalten des Anlassers an einen Festwertspeicher zu übertragen.
